**Europäisches Patentamt**

**European Patent Office**

**Office européen des brevets**

(19)

(11) Publication number: **0 111 394**
**A2**

## (12) EUROPEAN PATENT APPLICATION

(21) Application number: **83306834.9**

(22) Date of filing: **09.11.83**

(51) Int. Cl.³: **H 01 L 25/04**
**H 01 L 31/18**

(30) Priority: **09.11.82 US 440384**

(43) Date of publication of application:
**20.06.84 Bulletin 84/25**

(84) Designated Contracting States:
**BE ,CH DE FR GB IT LI NL**

(71) Applicant: ENERGY CONVERSION DEVICES, INC.
1675 West Maple Road
Troy Michigan 48084(US)

(72) Inventor: Izu, Masatsugu
15801 Providence Dr. Apt. 9B
Southfield Michigan 48075(US)

(72) Inventor: Ovshinsky, Herbert C.
15200 Leslie
Oak Park Michigan 48237(US)

(72) Inventor: Nath, Prem
245 Prospect
Rochester Michigan 48065(US)

(74) Representative: Boon, Graham Anthony et al,
Elkington and Fife High Holborn House 52/54 High
Holborn
London, WC1V 6SH(GB)

(54) Laminated strip of large area solar celle and method of producing that laminated strip.

(57) A continuous, lightweight, laminated strip (13, 106) of encapsulated, spaced, electrically interconnected, large area solar cells (40) includes an electrically-insulating, continuous, protective covering (90, 94) which encapsulates a plurality of said solar cells (40) so as to form either a modularized roll (13) or a modularized stack (106) of large area solar cells (40). Also disclosed herein is a method of fabricating the laminated strip (13, 106) of solar cells (40) from an elongated roll (9) of solar cell material which includes a substrate (11), a plurality of semiconductor layers (16a-c, 18a-c, 20a-c) deposited thereon and topped by an anti-reflective coating (22). The method of fabrication includes at least the steps of electrically interconnecting adjacent large area solar cells (40) of the solar cell material (9) and encapsulating the electrically-interconnected large area solar cells (40) between lightweight, elongated, continous, flexible, electrically-insulating upper (94) and lower (90) protective coverings. Specific uses of the laminated strip of encapsulated, spaced, electrically-interconnected, large area solar cells (13,106), such as roof top installation and repair are also described.

EP 0 111 394 A2

./...

COMPLETE DOCUMENT

FIG.5a.

Laminated Strip of Large Area Solar Cells and Method of
Producing that Laminated Strip

FIELD OF THE INVENTION

This invention relates generally to a module of
large area solar cells, and more particulary, to a
continuous, lightweight, laminated strip of spaced,
electrically-interconnected large area solar cells and a
method of fabricating same.

BACKGROUND OF THE INVENTION

This invention deals principally with (1) a
continuous, lightweight, laminated strip of
electrically-interconnected large area solar cells, and
(2) a method of fabricating that continuous, lightweight,
laminated strip of spaced electrically-interconnected,
large area solar cells from an elongated roll of solar
cell material. Generally, the method comtemplates the
production of either a modularized roll or a modularized
stack of large area solar cells from a roll of solar cell
material on an automated assembly line. The final
product is specially adapted for use to produce
electrical energy when operably installed on the
structure of residential or industrial buildings. Its
light overall weight, electrically pre-connected cells,
flexibility, and stacked or wound configuration provide
for ease of storage and handling, and economy in
installation and repair.

Although crystal silicon devices are the basis
of a huge semiconductor industry, devices made from
crystal silicon have fixed parameters which are not
variable as desired, require large amounts of material,
are only producible in relatively small areas and are
expensive and time consuming to produce. Devices based
upon amorphous silicon can eliminate these crystal
silicon disadvantages. Amorphous silicon has an optical
absorption edge having properties similar to a direct gap
semiconductor and only a material thickness of one micron

- 3. -

or less is necessary to absorb the same amount of sunlight as the 50 micron thick cyrstalline silicon. Further, amorphous silicon can be made faster and more easily in larger areas than can cyrstalline silicon.

Accordingly, a considerable effort has been made to develop processes for readily depositing amorphous semiconductor alloys or films, each of which can encompass relatively large areas, if desired, limited only by the size of the deposition equipment, and which could be readily doped to form p-type and n-type materials when p-n junction devices are to be made therefrom equivalent to those produced by their crystalline counterparts. For many years such work was substantially unproductive. Amorphous silicon or germanium (Group IV) films are normally four-fold coordinated and were found to have microvoids and dangling bonds and other defects which produce a high density of localized states in the energy gap thereof. The presence of a high density of localized states in the energy gap of amorphous silicon semiconductor films results in a low degree of photoconductivity and short carrier lifetime, making such films unsuitable for photoresponsive applications. Additionally, such films cannot be successfully doped or otherwise modified to shift the Fermi level close to the conduction or valence bands, making them unsuitable for making p-n junctions for solar cell and current control device applications.

In an attempt to minimize the aforementioned problems involved with amorphous silicon and germanium, W.E. Spear and P.G. Le Comber of Carnegie Laboratory of Physics, University of Dundee, in Dundee, Scotland, did some work on "Substitutional Doping of Amorphous Silicon", as reported in a paper published in Solid State Communications, Volume 17, pp. 1193-1196, 1975, toward the end of reducing the localized states in the energy gap in amorphous silicon or germanium to make the same approximate more closely intrinsic cyrstalline silicon or germanium and for substantially doping the amorphous materials with suitable classic dopants,, as in doping crystalline materials, to make them extrinsic and/or p or n conduction types.

The reduction of the localized states was accomplished by glow discharge depositon of amorphous silicon films wherein a gas of silane ($SiH_4$) was passed through a reaction tube where the gas was decomposed by an r.f. glow discharge and deposited on a substrate at a substrate temperature of about $500-600°$ K ($227-327°$ C). The material so deposited on the substrate was an intrinsic amorphous material consisting of silicon and hydrogen. To produce a doped amorphous material, a gas of phosphine ($PH_3$) for n-type conduction, or a gas of diborane ($B_2H_6$) for p-type conduction, were premixed with the silane gas and passed through the glow discharge reaction tube under the same operating conditions. The gaseous concentration of the dopants used was between about $5 \times 10^{-6}$ and $10^{-2}$ parts per volume. The material so deposited including supposedly substitutional phosphorus or boron dopant and was shown to be extrinsic and of n or p conduction type.

While it was not known by these researchers, it is now known by the work of others that the hydrogen in the silane combines at an optimum temperature with many of the dangling bonds of the silicon during the glow discharge deposition, to substantially reduce the density of the localized states in the energy gap toward the end of making the electronic properties of the amorphous material approximate more nearly those of the corresponding cyrstalline material.

- 5. -

The incorportion of hydrogen in the above method not only has limitiations based upon the fixed ratio of hydrogen to silicon in silane, but, more importantly, various Si:H bonding configurations introduce new antibonding states which can have deleterious consequences in these materials. Therefore, there are basic limitations in reducing the density of localized states in these materials which are particularly harmful in terms of effective p as well as n doping. The resulting density of states of the silane deposited materials leads to a narrow depletion width, which in turn limits the efficiencies of solar cells and other devices whose operation depends on the drift of free carriers. The method of making these materials by the use of only silicon and hydrogen also results in a high density of surface states which affects all the above parameters.

After the development of the glow discharge deposition of silicon from silane gas was carried out, work was done on the sputter depositing of amorphous silicon films in the atmosphere of a mixture of argon (required by the sputtering deposition process) and molecular hydrogen, to determine the results of such molecular hydrogen on the characteristics of the deposited amorphous silicon film. This research indicated that the hydrogen acted as an altering agent which bonded in such a way as to reduce the localized states in the energy gap. However, the degree to which the localized states in the energy gap were reduced in the sputter deposition process was much less than that achieved by the silane deposition process described above. The above described p and n dopant gases also were introduced in the sputtering process to produce p and n doped materials. These materials had a lower doping efficiency than the materials produced in the glow discharge process. Neither process produced efficient p-doped materials with suffiently high acceptor concentrations for producing commercial p-n or p-i-n junction devices. The n-doping efficiency was below desirable acceptable commercial levels and the p-doping was particularly undesirable since it reduced the width of the band gap and increased the number of localized states in the band gap.

Greatly improved amorphous silicon alloys having significantly reduced concentrations of localized states in the energy gaps thereof and high quality electronic properties have been prepared by glow discharge deposition as fully described in U.S. Patent No. 4,226,898, Amorphous Semiconductors Equivalent to Crystalline Semiconductors, Stanford R. Ovshinsky and Arun Madan which issued October 7, 1980, and by vapor deposition as fully described in U.S. Patent No. 4,217,374, Stanford R. Ovshinsky and Masatsugu Izu, which issued on August 12, 1980, under the same title. As disclosed in these patents, which are incorporated herein by reference, fluorine may be introduced into the amorphous silicon semiconductor to substantially reduce the density of localized states therein. Activated. fluroine readily diffuses into and bonds to the amorphous silicon in the amorphous body to substantially decrease the density of localized defect states therein, because the small size of the fluorine atoms enables them to be readily introduced into the amorphous body. It is believed that the fluorine bonds to the dangling bonds of the silicon and forms a partially ionic stable bond with flexible bonding angles, which results in a more stable and more efficient compensation or alteration than is formed by hydrogen and other compensating or altering agents. Fluorine is therefore thought to be a more efficient compensating or altering element than hydrogen when employed alone or with hydrogen because of its exceedingly small size, high reactivity, specificity in chemical bonding, and highest electronegativity.

As an example, compensation may be achieved with fluorine alone or in combination with hydrogen with the addition of these element(s) in very small quantities (e.g., fractions of one atomic percent). However, the amounts of fluorine and hydrogen most desirably used are much greater than such small percentages so as to form a silicon-hydrogen-fluorine alloy. Such alloying amounts of fluorine and hydrogen may, for example, be in the range of 1 to 5 percent or greater. It is believed that the new alloy so formed has a lower density of defect states in the energy gap than that achieved by the mere neutralization of dangling bonds and similar defect states. Such larger amount of fluorine, in particular, is believed to participate substantially in a new structural configuration of an amorphous silicon-containing material and facilitates the addition of other alloying materials, such as germanium. Fluorine, in addition to its other characteristics, mentioned herein, is believed to be an organizer of local structure in the silicon-containing alloy through inductive and ionic effects. It is believed that fluorine also influences the bonding of hydrogen by acting in a beneficial way to decrease the density of defect states which hydrogen contributes while acting as a density of states reducing element. The ionic role that fluorine plays in such an alloy is believed to be an important factor in terms of the nearest neighbor relationships.

It must be emphasized that the role that flourine plays in bonding with silicon, hydrogren, germanium or other like elements is not as yet understood. However, the chemical composition of the semiconductor layers is not a critical aspect of the laminated strip of electrically-interconnected large area photovoltaic cells of the present invention. The laminated strip and the method of producing said strip presuppose that photovoltaic material of acceptable quality is available, without regard to whether that semiconductor material is (1) formed from pure silane, germanium, or includes traces of flourine; (2) is crystalline, polycrystalline or amorphous; or (3) inncludes single or multiple seminconductor cells. As regards the instant invention, it is only important that the semiconductor material and substrate have the inherent ability to be wound about a large diameter spool.

It is now known that the efficiency of a photovoltaic device may be enhanced by stacking cells atop of each other. This concept of utilizing multiple cells, to enhance photovoltaic device efficiency, was discussed at least as early as 1955 by E.D. Jackson, U.S. Patent No. 2,949,498 issued August 16, 1960. The multiple cell structures therein discussed utilized p-n junction crystalline semiconductor devices. Essentially the concept is directed to utilizing different band gap devices to more efficiently collect various portions of the solar spectrum and to increase open circuit voltage (Voc.). The tandem cell device has two or more cells with the light directed serially through each cell, with a large band gap material followed by a smaller band gap material to absorb the light passed through the first cell or layer. By substantially matching the generated currents from each cell, the overall open circuit voltage of each cell may be added, thereby producing a device which makes full use of the energy produced by incoming light.

Many publications on crystalline stacked cells following Jackson have been reported and, more recently, several articles dealing with Si-H materials in stacked cells have been published. Marfaing proposed utilizing silane deposited amorphous Si-Ge alloys in stacked cells, but did not report the feasibility of doing so. (Y. Marfaing, Proc. 2nd European) Communities Photovoltaic Solar Energy Conf., Berlin, West Germany, p. 287, (1979).

Hamakawa et al., reported the feasibility of utilizing Si-H in a configuration which will be defined herein as a cascade or tandem type mutliple cell. The cascade cell is hereinafter referred to as a multiple cell without a separation or insulating layer therebetween. Each of the cells was made of an Si-H material of the same band gap in a p-i-n junction configuration. Matching of the short circuit current (J sc$\mu$) was attempted by increasing the thickness of the cells in the serial light path. As expected, the overall device Voc. increased and was proportional to the number of cells so stacked.

Due to the beneficial properties attained by the introduction of fluorine, amorphous alloys used to produce cascade type multiple cells may now incorporate fluorine to reduce the density of localized states without impairing the electronic properties of the material. Further band gap adjusting element(s), such as germanium and carbon, can be activated and are added in vapor deposition, sputtering or glow discharge processes. The band gap is adjusted as required for specific device applications by introducing the necessary amounts of one or more of the adjusting elements into the deposited alloy cells in at least the photocurrent generation region thereof. Since the band gap adjusting element(s) has been tailored into the cells without adding substantial deleterious states, it is believed, because of the influence of fluorine, the cell alloy maintains high electronic qualities and photoconductivity when the adjusting element(s) are added to tailor the device wavelength characteristics for a specific photoresponse application. The addition of hydrogen can further enhance the fluorine compensated or altered alloy. The post deposition incorporation of hydrogen is advantageous when it is desired to utilize the higher deposition substrate temperatures allowed by fluorine.

It is of obvious commercial importance to be able to mass produce photovoltaic devices. Unlike crystalline silicon which is limited to batch processing for the manufacture of solar cells, amorphous silicon alloys can be deposited in multiple layers over relatively large area substrates to form solar cells in a high volume, continous processing system. Continuous processing systems of this kind are disclosed, for example, in pending patent applications: Serial No. 151,301, (Pat No. 4400409), for A Method of Making P-Doped Silicon Films and Devices Made Therefrom; Serial No. 244,386, filed March 16, 1981 for Continuous Systems For Depositing Amorphous Semiconductor Material; Serial No. 240,493, filed March 16, 1981 for Continuous Amorphous Solar Cell Production System; EPA No. 82108699.8, filed September 21, 1982 for Multiple Chamber Deposition and Isolation System and Method; and Serial No. 359,825, filed March 19, 1982 for Method and Apparatus for Continuosly Producing Tandem Photovoltaic Cells. As disclosed in these applications, a substrate may be continuously advanced through successive triads of deposition chambers, wherein each chamber is dedicated to the deposition of a specific material. In making a solar cell of p-i-n-type configuration, the first chamber of each triad is dedicated for depositing a p-type amorphous semiconductor material, the second chamber of each triad is dedicated for depositing an intrinisic semiconductor material, and the third chamber of each triad is dedicated for depositing an n-type amorphous semiconductor material. Whereas the foregoing patents and patent applications dealt with glow discharge deposition processes in which r.f. power was used to develop the plasma, the semiconductor layers may also be deposited onto a continuously moving substrate by a glow discharge deposition process in which microwave energy develops the plasma.

The resultant roll of large area solar cells, which is manufactured by the mass production glow discharge deposition technique described hereinabove, comprises an elongated substrate upon which successive amorphous semiconductor layers are deposited. While in the preferred embodiment, the substrate is stainless steel, other non-conductive substrate, such as glass, may be employed if an electrically conductive coating is applied thereon. It is well known that following the deposition of the amorphous semiconductor layers, a further step must be performed in order to complete fabrication of an operable, amorphous semiconductor device. In this step, an anti-reflective coating, which is characterized by high light-transmissivity and high electrical-conductivity, is deposited atop the amorphous semiconductor body. The anti-reflective coating may, for example, be indium tin oxide (ITO), cadmuim stannate (Cd $2 \mu$S, NuO $4 \mu$), doped tin oxide (S NuO $2 \mu$) or other known materials. For a small area tandem cell, the anti-reflective coating is generally sufficiently electrically conductive so further application of a grid pattern is not necessary. However, if the tandem cell is of sufficiently large area, or if the conductivity of the anti-reflective coating is determined to be unsatisfactory, a grid pattern may be applied atop the anti-reflective coating to shorten the carrier path and increase the electrical conduction efficiency thereof.

The present invention, which deals with a laminated strip of encapsulated, electrically-connected large area solar cells, includes the division of each large area solar cell into a plurality of substantially isolated segments for purposes of increasing the electrical conduction of the semiconductor layers and for testing the efficiencies of small surface area portions of the solar cell material. In the preferred embodiment, the continuous, laminated strip of large area solar cells is fabricated from the roll of solar cell material, after the application of the transparent, conductive coating, but before the application of a conductive grid pattern atop the transparent, conductive coating. However, this invention is equally well suited and readily adapted for fabricating the laminated strip of large area solar cells from a roll of solar cell material on which the grid pattern has already been applied. A discussion of one technique for placing a grid pattern onto the transparent, conductive coating so as to electrically-isolate small surface area segments of the large area solar cells on the roll of solar cell material is found in copending British Patent Application, No. 2114815 A, filed February 10, 1983, and of common assignment with the invention disclosed herein.

Included in the prior art is United States Patent No. 4,281,208 filed January 29, 1980, and assigned to

- 13. -

Sanyo Electric Co., Ltd. Disclosed therein is a photovoltaic device comprising an insulating, glass substrate on which amorphous p-i-n layers are continuously formed. Transparent electrodes from the substrate and aluminum electrodes from the amorphous layers are electrically connected to adjacent opponent electrodes to withdraw power in series fashion. While that Sanyo patent relates to a method of producing interconnected semiconductor devices on a mass production basis, it neither discloses nor suggests a laminated strip of large area cells which is flexible, lightweight, capable of being wound into a modularized roll and readily severable between adjacent large area cells for on site installation and/or repair. It further fails to disclose or suggest an assembly line technique which can be used to produce the laminated strip of continuous, flexible, lightweight, spaced, encapsulated, electrically- interconnected, large area solar cells taught herein. The Sanyo patent merely discloses a production technique which involves a complex arrangement of photoelectric regions to achieve a series connection therebetween. The device utilizes a heavy, inflexible glass substrate which, like other prior art modules, cannot be wound into roll form and would be nearly impossible to adapt for in situ installation and/or repair.

One preferred embodiment of the present invention relates to a continous, flexible, laminated strip of spaced, electrically-interconnected large area solar cells fabricated from an elongated roll of solar cell material. The solar cell material comprises a substrate having deposited thereon a plurality of p-i-n-type semiconductor layers, covered by an electrically conductive, light transmissive, anti-reflective coating.

The solar cell material is divided into a plurality of spaced, large area solar cells by insulating material which prevents the transparent, conductive coating from establishing electrical-contact with the semiconductor layers. That insulating material may also be applied to the upper periphery of each cell to facilitate electrical-interconnection of adjacent large area solar cells as will be more fully described hereinafter. An important aspect of the fabrication process by which the laminated strip is produced is its ability to complete the manufacture of the laminated strip on an automated, assembly line basis. An important aspect of the product produced by that process is the improved flexibility which a modularized roll or modularized stack of electrically-interconnected, large area solar cells provides for storage and use.

In other words, now that amorphous semiconductor material can be produced on a mass production basis, it is possible, for the first time to correspondingly mass produce modularized solar cell panels. The instant process provides a mass production technique which not only allows manufacture of modules on an assembly line, but produces those modules in either rolled-up or stacked form. The modularized roll or stack of electrically-interconnected large area solar cells are easily conveyed to a job site where they may be sized and matched to job specifications in situ. For instance, if the electrically-interconnected, large area solar cells typically produce a pressure of one volt and a current of six amperes, the number of large area solar cells to be installed will depend on the power requirements of the particular customer. A customer's power requirement of 180 watts is easily matched by cutting and installing thirty of such electrically-interconnected, large area solar cells. This is in direct contrast to previous solar cell panels which used a basic four foot long and two foot wide module and were therefore limited to power produced from multiples of eight large area solar cells. It cannot be stressed to greatly that the laminated strip of large area solar cells disclosed herein is specially structured for field adaption to meet the power requirements of specific job applications. While the example given supra was tailored for the production of 6 watt building blocks, it should be readily apparent that the same manufacturing process, by electrically-interconnecting large area solar cells of smaller overall dimensions can be used for the production of smaller incremental quantities of electrical power, such as one watt increments. However, using a large area solar cell building block providing one volt of pressure, common voltage requirements of two volts, eight volts, etc. can easily be provided in situ. The cost savings of (1) not having to return to the factory to encapsulate the solar cells for every application, and (2) having the ability to make instanteous changes at the job site are of immeasurable economic importance.

A further advantage of the present invention relates to cost. While some analysts, comparing the cost per watt of power produced from solar energy with the cost per watt of power produced from conventional energy sources were previously of the opinion that efficiencies of the amorphous solar cells had to reach higher levels than currently available before solar energy could compete economically with conventional sources. However, such predictions took into account certain fixed production, assembly and installation and repair costs. By the present invention, and especially in the embodiment in which the laminated strip of large area cells additionally functions as a shingle for roof-top installations, applicants have substantially decreased the cost of assembly, installation and repair of solar cell modules and have, therefore, unquestionably made amorphous solar cells, at current efficiency levels, cost effective.

These innovations, as well as many other objects and advantages of the instant invention will become clear from an analysis of the drawings, the description of the invention and the claims which follow:

## BRIEF SUMMARY OF THE INVENTION

Disclosed herein is a continuous, flexible, lightweight, laminated strip of encapsulated, spaced, electrically- interconnected, large area solar cells. The laminated strip includes a lower, continuous, flexible, electrically-insulating protective covering. Spacedly secured to the protective lower covering are a plurality of spaced, electrically-interconnected large area solar cells. Each solar cell includes a substrate, a plurality of semiconductor layers atop the substrate and an electrically-conductive, transparent, light-transmissive, anti-reflective coating deposited atop the semiconductor layers. Finally, an upper continuous, flexible, electrically-insulating, light-transmissive protective covering is laminated atop the spaced, electrically-interconnected large area solar cells to form the continuous laminated strip of spaced, electrically-connected large area solar cells. The laminated strip is either wound into a modularized roll of large area solar cells, or is folded into a modularized stack of large area solar cells. The large area solar cells are preferably electrically connected in series.

Also disclosed is a method of fabricating a continuous, flexible, lightweight, laminated strip of spaced, encapsulated, electrically-interconnected large area solar cells from an elongated roll of solar cell material. The solar cell material is formed of a substrate having deposited thereon a plurality of semiconductor layers and covered by a transparent electrically-conductive, light-transmissive transparent, conductive coating so as to form a plurality of large area solar cells. The inventive method includes the steps of moving the solar cell material from a pay-off station, through a plurality of work stations where the solar cell material is divided into a plurality of encapsulated, electrically- connected, large area solar cells. A take-up station is provided for either winding the laminated strip of large area solar cells into a modularized roll or folding the laminated strip into a stack of electrically-interconnected, large area solar cells. In its most specific form, the method may include the steps of: (1) securing a plurality of elongated busbars to each large area solar cell at a first work station; (2) printing a plurality of grid patterns onto the transparent, conductive coating of electrically-isolated segments of each large area solar cell and electrically-interconnecting the electrically-isolated segments of each large area solar cells to adjacent busbars at a second work station; (3) cutting the large area solar cells to a predetermined size from the solar cell material at a third work station; (4) testing each large area solar cell for electrical-operability at a fourth work station; (5) removing electrically-inoperable large area solar cells from the assembly line at a fifth work station; (6) replacing the removed, defective, large area solar cells with electrically-operable large area solar cells at a sixth work station; (7) priming the lower surface of the large area solar cells and, spacing the cut, large area solar cells a preselected distance apart onto the continuous roll of flexible, electrically-isolating, lower, protective covering at a seventh work station; (8) electrically-interconnecting adjacent, large area solar cells, at an eighth work station; (9) priming the upper surface of the electrically-interconnected, large area solar cells and introducing the continuous roll of flexible, electrically-insulating, light-transmissive, upper protective covering at a ninth work station; and (10) laminating the upper and lower protective coverings onto opposite surfaces of the large area solar cells in a heating, vacuum, flowing and curing chamber disposed at a tenth work station.

There is further disclosed herein a method of installing a solar cell module on the structure of a residential or industrial building. The method includes the steps of cutting a solar cell module into a length sufficient to produce the predetermined voltage requirements of said building from a continuous modularized roll of spaced, electrically-interconnected large area solar cells which are encapsulated by upper and lower protective coverings. The solar cell module is then secured to the roof of the building, as by nailing, and electrically-connected for use.

A further aspect of the present invention is a method of replacing a damaged large area solar cell which, as part of a solar cell module installed on the structure of a residential house or industrial building, is electrically-interconnected to adjacent large area solar cells. The solar cell module includes a continuous length of spaced, electrically-interconnected large area solar cells encapsulated by upper and lower protective coverings. The method includes the steps of: electrically disconnecting and physically removing the damaged large area solar cell from the remainder of the large area cells of the module, electrically connecting and physically inserting a similarly sized large area replacement solar cell to the remainder of the large area solar cells of the module and sealing the protective upper and lower coverings of the replacement solar cell to the upper and lower coverings of the remainder of the solar cell module.

Finally, there is disclosed a solar cell module comprising a preselected number of lightweight, flexible, laminated, encapsulated, spaced, electrically-interconnected, large area solar cells, each cell including a substrate and a plurality of semiconductor layers atop the substrate. A flexible, lightweight covering encapsulates the spaced, electrically-interconnected large area cells and elongated positive and negative leads are electrically connected to and extend from the module. In this manner, the module may be installed on a roof, while all electrical connections are completed at the junction box or another remote location.


BRIEF DESCRIPTION OF THE DRAWINGS


Figure 1 is a greatly enlarged fragmentary, cross-sectional view of a continuous length of solar cell material comprising one or a plurality of p-i-n type solar cells, each layer of the cells preferably formed of a semiconductor alloy;

- 20. -

Figure 2a is a fragmentary top plan view of one embodiment of the present invention illustrating the electrical grid pattern formed on the rows and columns of electrically-isolated small area segments of the transparent, conductive coating;

Figure 2b is a fragmentary top plan view illustrating the electrically-isolated, small area segments of Figure 2a before the application of a grid pattern onto the transparent, conductive coating;

Figure 3 is a top plan view illustrating one preferred method of electrically-interconnecting adjacent large area solar cells;

Figure 4a is an elevational view illustrating schematically, the assembly line arrangement of machinery to perform successive (1) busbar laminating, (2) grid pattern printing and busbar connecting, (3) drying, and (4) cutting and sheeting operations on a roll of solar cell material;

Figure 4b is an elevational view illustrating schematically, the assembly line arrangement of machinery continuing from the cutting and sheeting operation of Figure 4a through successive (5) electrical testing, (6) sorting, (7) orienting, (8) substrate exposing and (9) electrically- interconnecting operations;

Figure 4c is an elevational view illustrating schematically the assembly line arrangement of machinery continuing from the electrically-interconnecting operation of Figure 4b through successive (10) welding, (11) soldering, and (12) lower priming operations;

Figure 4d is an elevational view illustrating schematically one embodiment of the assembly line arrangement of machinery continuing from the lower priming operation of Figure 4c through successive (13) lower encapsulating (14) upper priming, (15) upper encapsulating, (16) curing, and (17) winding operations;

Figure 4e is an elevational view illustrating schematically a further embodiment of the assembly line arrangement of machinery continuing from the curing operation of Figure 4d through a successive (17) stacking operation;

Figure 5a is predominantly a perspective view illustrating the successive operations performed on the roll of solar cell material traveling through the machinery shown in Figure 4a;

Figure 5b is predominantly a perspective view illustrating the successive operations performed on the roll of solar cell material traveling through the machinery shown in Figure 4b;

Figure 5c is predominantly a perspective view illustrating the successive operations performed on the roll of solar cell material traveling through the machinery shown in Figure 4c;

Figure 5d is predominantly a perspective view illustrating the successive operations performed on the roll of solar cell material traveling through the machinery shown in Figure 4d; and

Figure 5e is predominantly a perspective view illustrating the successive operations performed on the roll of solar cell material traveling through the machinery shown in Figure 4e.

## DETAILED DESCRIPTION OF THE DRAWINGS

### I.    The Solar Cell Material

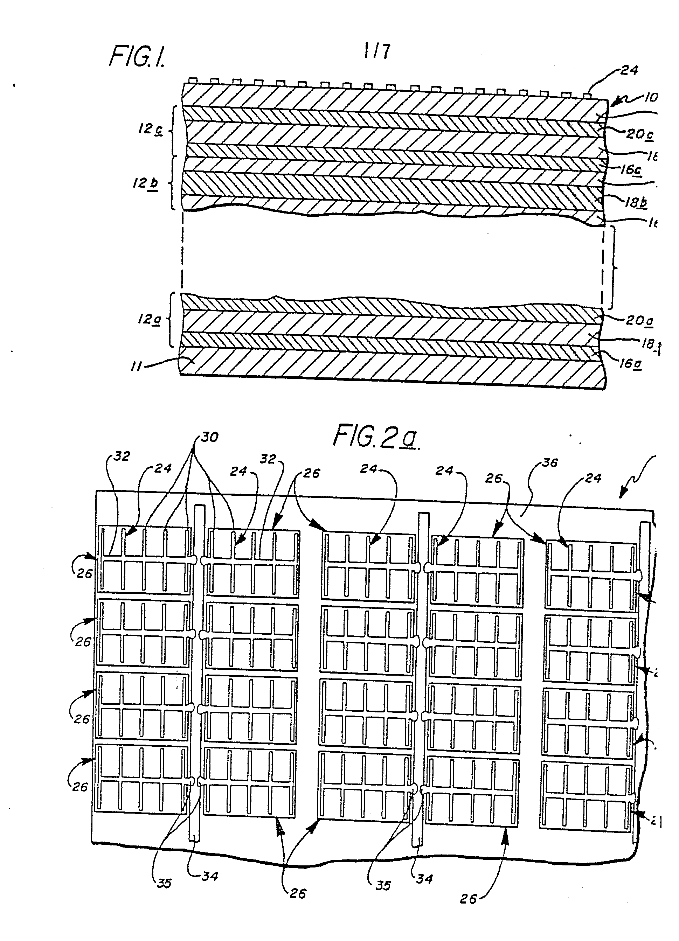

Referring now to the drawings and particularly to Figure 1, tandem or cascade-type solar cell material, including successive p-i-n semiconductor-type layers, each layer preferably formed from an amorphous semiconductor alloy, and including an upper transparent, conductive coating, is shown generally by the reference numeral 10. It is from an elongated, continuous roll of this type of solar cell material, wherein semiconductor layers are deposited onto a large area web of substrate material, which the fabrication of the continuous, flexible, lightweight, laminated strip of spaced, electrically-interconnected, large area solar cells of the present invention begins.

More particularly, Figure 1 shows a plurality of p-i-n type semiconductor layers such as cells 12a, 12b and 12c. Below the lowermost cell 12a is a substrate 11 which may be transparent or formed from a metallic surfaced foil. Although certain applications may require a thin oxide layer and/or a series of base contacts prior to application of the amorphous material, for purposes of this application, the term "substrate" shall include not only a flexible film, but also any elements added thereto by preliminary processing. Most commonly the substrate material 11 may be stainless steel, aluminum, tantalum, molybdenum or chrome.  Also included within the scope of the present invention are substrates formed of glass or a glass-like material on which an electrically conductive electrode is applied.

Each of the cells 12a, 12b and 12c are fabricated with an amorphous semiconductor body.  Although typically containing at least a silicon alloy, other alloys or materials may also be employed, with or without the addition of flourine.  Each of the semiconductor bodies includes an n-type conductivity region or layer 20a, 20b and 20c; an intrinsic region or layer 18a, 18b and 18c; and p-type conductivity region or layer 16a  16b and 16c.  As illustrated, cell 12b is an intermediate cell and, as indicated in Figure 1, additional intermediate cells may be stacked atop the illustrated cells without departing from the spirit or scope of the present invention. Also, although tandem p-i-n solar cell material is illustrated, the modularized roll of large area solar cells of this invention may also be produced from solar cell material having n-i-p orientation.

For each of the cells 12a, 12b and 12c, the p-type layers are characterized by light absorptive, high conductivity amorphous semiconductor layers.  The intrinsic amorphous semiconductor layers are characterized by an adjusted wavelength threshold for solar photoresponse, high light absorption, low dark conductivity and high photoconductivity, including sufficient amounts of a band gap adjusting element or elements to optimize the band gap for the particular cell application.  Preferably, the intrinsic layers are band gap adjusted to provide cell 12a with the smallest band gap, cell 12c with the largest band gap, and cell 12b with a band gap between the other two.  The n-type layers are characterized by low light absorption and high
conductivity. The thickness of the n-type layers can be
in the range of about 25 to 100 angstroms. The thickness
of the band gap adjusted, amorphous semiconductor
intrinsic layers can be between about 2,000 to 3,000
angstroms. The thickness of p-type layers can be between
50 to 200 angstroms. Due to the shorter diffusion length
of the holes, the p-type layers generally will be as thin
as possible. Further, the outermost layer, here the
n-type layer 20c, will be as thin as possible to avoid
absorption of light and need not include the band gap
adjusting element.

It is to be understood that following the
deposition of the amorphous semiconductor layers, a
further deposition step may be performed in a separate
environment. In this step, an transparent, conductive
coating of high electrical-conductivity and high
light-transmissivity is deposited atop the semiconductor
layers. The transparent, conductive coating may, for
example, be indium tin oxide (ITO), cadmium stannate
($Cd_{2\mu}SnO_{4\mu}$), or doped tin oxide ($SnO_{2\mu}$). Although an
electrode grid pattern 24 may be added to the solar cells
material, for applications involving a sufficiently small
area solar cell, the transparent, conductive coating 22
is generally sufficiently conductive so a grid pattern 24
is not necessary. However, for applications such as the
present one in which large area (one square foot) solar
cells are being fabricated, a grid pattern 24 should be
placed on the layer 22 to shorten the carrier path and
increase the conduction efficiency thereof.

Prior to depositing the transparent, conductive
coating 22, the continuous roll of solar cell material
travels through a chamber in which an
electrically-insulating material masks portions of the continuous roll. In this manner, the plurality of continuous, spaced, one square foot, large area solar cells are formed by applying an electrically-insulating mask between the active semiconducter layers and the electrically-conductive, transparent, conductive coating to be applied in a downstream operation. It should be understood that the solar cell material 10 can be divided into other sizes by the electrically-insulating material, such as two inch by twelve inch large area solar cells, to meet specific installation and electrical requirements. Further, the electrically-insulating material can be used to divide the surface area of the large area segments of solar cell material now formed on the roll of solar cell material into a plurality of electrically-isolated segments. This isolation will be better understood after reading the preferred methods of electrically-connecting large area solar cells covered in Section II which follows hereinafter. Note that while this method of spacedly forming large area solar cell material on the roll of solar cell material does not constitute part of the claimed invention, it is readily incorporated in the assembly line process disclosed herein.

II.    The Grid Pattern and Electrical Connections of

Isolated Segments of Large Area Solar Cells


Figure 2a is a fragmentary view of the upper surface of the transparent, conductive coating 22 applied atop the semiconductor layers of the roll of solar cell material 10. As can be readily determined from that figure, the surface area of the semiconductor layers of

- 26. -

the solar cell material 10 is divided into a plurality of electrically isolated segments 26 in any one of a plurality of methods which will be described hereinafter. Although the exact number and arrangement of the isolated segments 26 of the solar cell material 10 may vary, in the preferred embodiment, twelve (12) parallel rows of fifteen (15) isolated segments 26 (a total of one hundred-eighty subcells) define the surface area of each large area (one square foot) solar cell into which the roll of solar cell material 10 is preferably divided. The term "isolated segment" is defined herein as a small surface area segment of a large area solar cell which is electrically-isolated from other segments of the surface area of the large are solar cell, but which shares a common substrate or electrode with those other segments.

The isolated segments 26 are formed, in the preferred embodiment, by discrete portions of the transparent, conductive coating 22 deposited atop the semiconductor layers of the solar cell material 10. Each isolated segment 26 may also be formed from the transparent, conductive coating 22 by other known method such as photolithography and chemical etching. For instance, a photoresist solution may be applied to the surface of the transparent, conductive coating 22 and pre-heated to dry off solvents, thus leaving a thin film as a residue. The grid pattern 24, one possible form of which will be described hereinafter, is then laid over the residual film, and those portions of the film not covered by the pattern are exposed to electro-magnetic radiation, typically in the ultra-violet region of the spectrum, or to a beam of electrons of appropriate energy to develop the film. During the development of the film, using conventional chemical or plasma procedures, the exposed portions (positive resist) or the unexposed portions (negative resist) of the film and the underlying transparent, conductive coating 22 are removed. The residual photoresist film is washed with a solvent to remove same from the surface of the anti-relective coating 22. A grid pattern 24 may now be applied onto the surface of the now isolated segments 26 of the transparent, conductive coating 22.

During the course of the foregoing processing, the drying or curing process includes so-called "pre-bake" and "post-bake" steps which may be implemented by heating the photoresist solution to about 95 degrees to 120 degrees C for about 20-25 minutes. As an alternative, microwave curing, or any other well known curing technique may be employed. Such alternate techniques are used either (1) to reduce the length of dry time or (2) maintain the lower layers of the triad of amorphous layers of the solar cell near ambient temperature.

In the embodiment illustrated in Figure 2b, the isolated segments 26 of the solar cell material 10 can be formed by dividing the transparent, conductive coating 22 into plurality of discrete segments 22a-22u without applying a grid pattern thereonto. It is to be understood that for purposes of this description, the numeral 26 will refer to isolated segments of the transparent, conductive coating with a grid pattern applied thereonto, while the numerals 22a-22u refer to isolated segments of the transparent, conductive coating 22 not having the grid pattern applied thereonto. The discrete segments 22a-22u of the transparent, conductive coating 22 may be formed either by originally depositing the transparent, conductive coating 22 in a discontinous fashion, as by the application of the insulating material as previously described, or by depositing a continuous transparent, conductive coating 22 and then removing intermediate parts by the photolithography and etching technique previously described. Note that the electrically-insulating material may be applied atop the semiconductor layers by means of screen printing or other known techniques.

Each isolated segment, whether formed by a continuous or discontinuous transparent, conductive coating may have a grid pattern 24 applied thereonto. The width dimension of each grid pattern 24 is defined by a plurality of substantially equally spaced, relatively thin, parallel, electrically-conductive lines 30 radiating perpendicularly from both sides of a tapered, relatively thick, electrically-conductive, busbar-connecting line 32 which defines the length dimension of the grid pattern 24. The total width of each isolated segment 26 is about three-quarters (3/4) of an inch and the total length of each isolated segment 26 is about one (1) inch. The grid patterns 24 are formed so as to maximize the current collected from the solar cell material while minimizing the amount of light prevented from entering the solar cell material. In the preferred embodiment wherein a grid pattern 24 is applied to a single p-i-n cell, each grid pattern 24 includes ten (10) parallel lines 30 and the busbar-connecting line 32 increase in thickness from to a minimum dimension at the free end thereof to a maximum dimension of approximately one-sixteenth (1/16) of an inch at the busbar-connecting end thereof. It should be readily apparent to one ordinarily skilled in the art that the arrangement of isolated segments 26, the length and width dimensions of the grid patterns 24 and the isolated segments 26, the number of parallel lines 30, the number of parallel rows of the isolated segments 26, the total number of isolated

- 29. -

segments 26 formed on a large area solar cell and hence, the size and configuration of that solar cell may vary with the application of tandem cells to the substrate without departing from the spirit and scope of the present invention. Whatever arrangement is selected, the grid patterns 24 may be printed, by any well known technique, such as screen printing or evaporation, onto the transparent, conductive segments 26 with an electrically conductive material such as silver paste.

While two methods of forming the isolated segments 26 of the solar cell material have been described, other well known methods of "scribing" those isolation segments are within the scope of the present invention. Moreover, when used herein, the term "scribing" is intended to emcompass all such methods of removing the transparent, conductive coating 22, which include, but are not limited to: (a) chemical etching; (b) plasma etching; (c) various laser techniques; (d) a waterjet technique; or (e) applying the transparent, conductive coating with a mask to form said distinct, discontinous segments.

If desired, each isolated segment of the solar cell material 10 may be individually tested to determine whether the electrical output therefrom is sufficient to render it "electrically operative" or "electrically operable". As used within the context of the instant application, the terms "electrially operative isolated segment" or "electrically operable isolated segment" refer to those isolated segments 26 of the solar cell material which 10 provide satisfactory electrical output. The elctrical connection of isolated segments 26 of the solar cell material 10 providing unsatisfactory electrical output reduces the overall efficiency of the solar cell material. Further, since the isolated segments 26 of large area solar cells are connected in parallel, the electrical connection of any isolated segment 26 on a large area solar cell providing a very low voltage output could significantly decrease the electrical output of the entire large area solar cell 10.

A plurality of elongated, copper, electrically-conductive strip or busbars 34 are now affixed to the surface of the semiconductor layers with an electrically-insulating adhesive such as silicon. The adhesive is applied as a very thin layer because the busbars 34 are to be positioned between alternate rows of isolated segments 26 of the solar cell material. In other words, even after the busbars 34 are affixed to the solar cell material 10, a lateral gap must remain between adjacent discrete segments 26 of the transparent, conductive coating 26 and the associated busbar 34. In a preferred embodiment, wherein twelve rows of isolated segments 26 are provided, six conductive busbars 34, about 1/8 of an inch wide and .003 of an inch thick, are employed. The busbar-connecting ray 32 from each electrically-operative isolated segment 26 of the solar cell material is electrically-connected to an adjacent busbar 34 using a dot of electrially-conductive material such as silver paste 35. Those isolated segments 26 whose electrical output falls below the selected minimum satisfactory level remain electrically-isolated, by the insulating silicone adhesive, from the electrically-conductive copper busbar 34.

The foregoing sequence may be reversed and, in fact, once the incidence of electrically-operative, isolated segments 26 routinely exceeds a predetermined level, the testing step may be omitted. In such cases, it is actually desirable to reverse the sequence and adhesively secure the copper busbars 34 to the surface of transparent, conductive coating 22 prior to printing the grid patterns 24 onto the isolated segments 26. This reversed sequence is preferable because the grid patterns 24 and the electrical connections thereof to the copper busbars 34 may be simultaneously accomplished. Although the sequence is not important from an operational standpoint, it is significant from an assembly line standpoint where the elimination of a step can represent important economic gains.

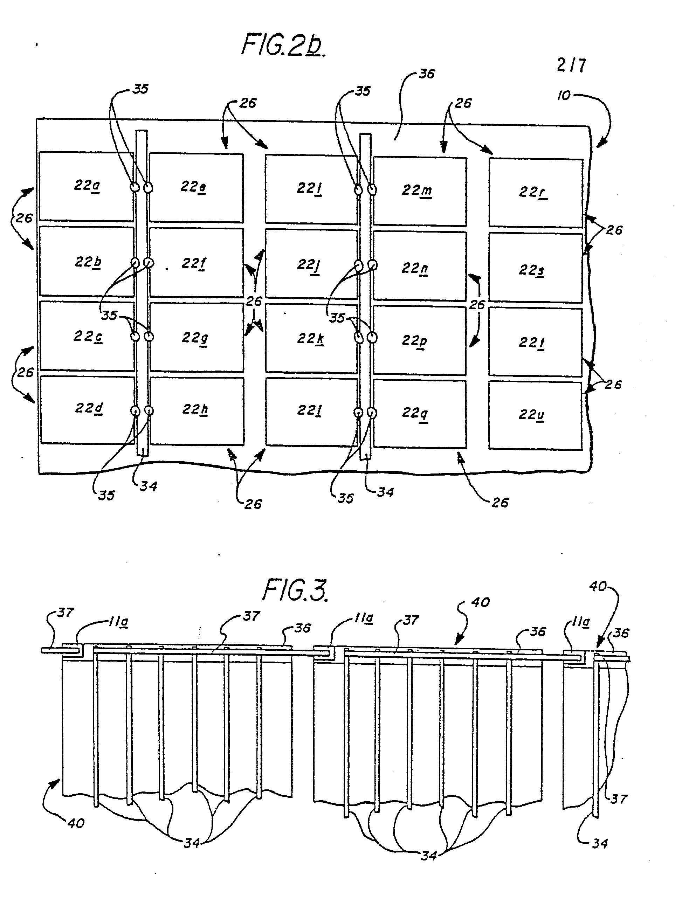

As can be seen from the preferred embodiment illustrated in Figure 3, the ends of the six copper busbars 34 extend beyond the periphery of the active area of each large area solar-cell and terminate on the upper circumferential border 36 to which an electrically-insulating layer of any well known type is applied (this could be accomplished simultaneously with the application of electrically-insulating material to the roll of solar cell material which forms the adjacent large area cells and the electrically-isolated small area segments thereof). The insulating layer is necessary to prevent the copper busbars 34 from contacting the substrate 11 and shorting the large area solar cell.

The upper left hand corner of each of the large area solar cells is burnished to expose the surface of the substrate 11. The exposed substrate surface 11a of one large area solar cell may be electrically-connected to an electrically- conductive, elongated copper strip 37 which electrically- interconnects the busbars of the adjacent large area solar cell. In this manner, a series connection between adjacent large area solar cells is provided, said connection being readily adaptable for assembly line application. Note that while Figure 3 illustrates the use of a single elongated strip 37 for connecting each pair of adjacent large area solar cells, a continuous strip may also be employed to interconnect a plurality of adjacent cells. The continuous strip would only require the addition of spaced electrically-insulating layers between the exposed substrate surface 11a and the busbars 34 of individual large area solar cells.

If desired, the output of the entire large area solar cell may be electrically tested at this time by simply connecting a lead from the six busbars 34 and the substrate. Only those large area solar cells providing satisfactory electrical output values will be electrically-interconnected to adjacent large area solar cells and subsequently encapsulated.

It must be noted that connecting the discrete large area solar cells in series, the electrically-conductive strip 37 need only be of a size sufficient to carry the current of a single discrete large area solar cell while adding the voltage from the plurality of electrically-interconnected large area solar cells. The series connection is therefore preferable to a parallel connection which could reqauire a conductive strip 37 of progressively increasing cross-sectional size.

III. The Assembly Line for Fabricating a Modularized

Roll of Electrically-Interconnected Large Area

Solar Cells

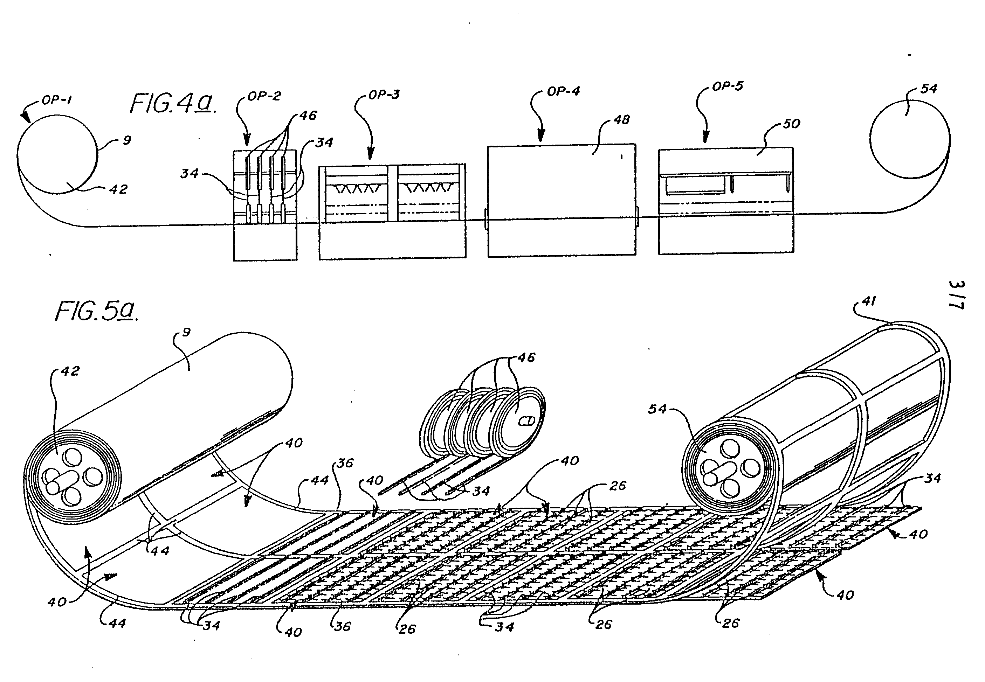

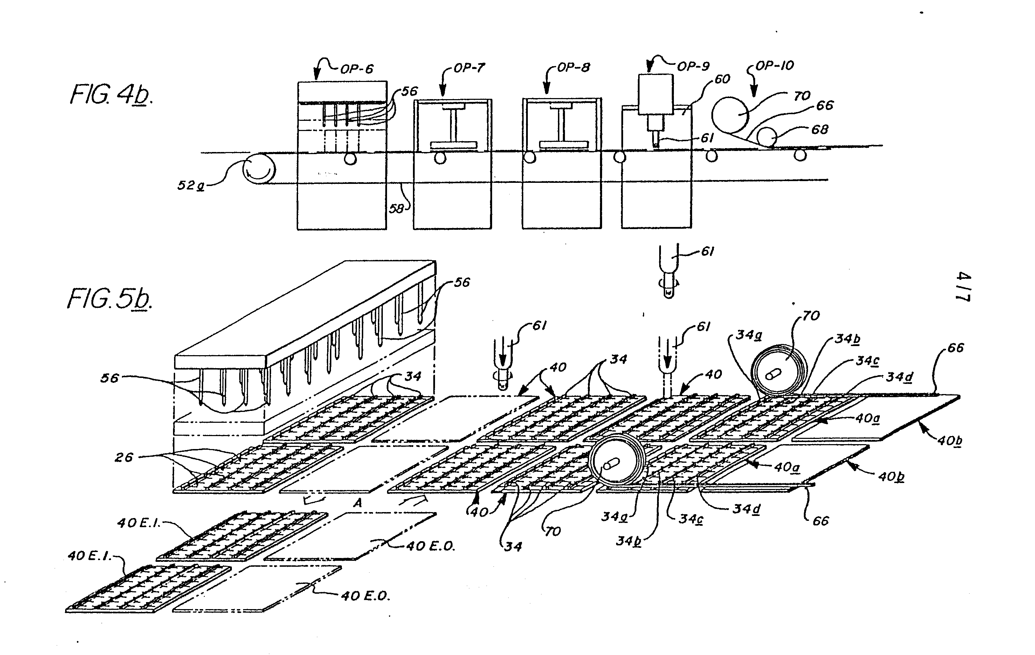

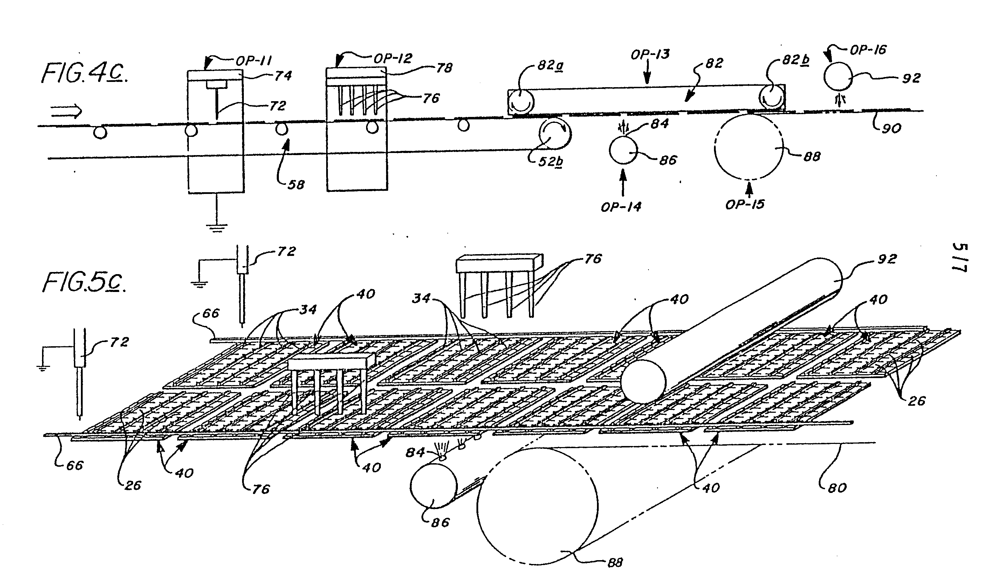

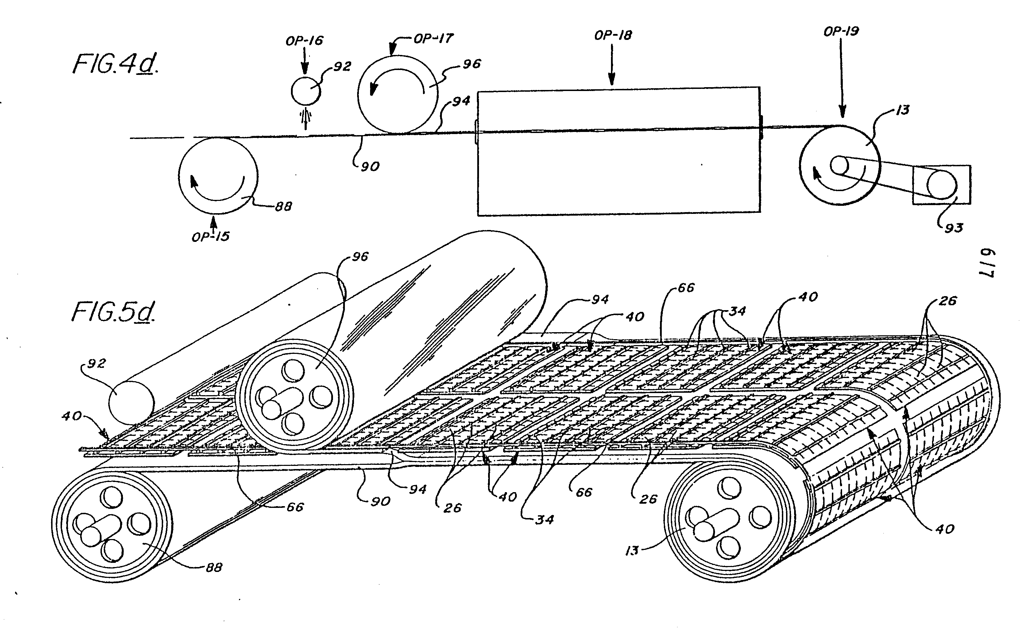

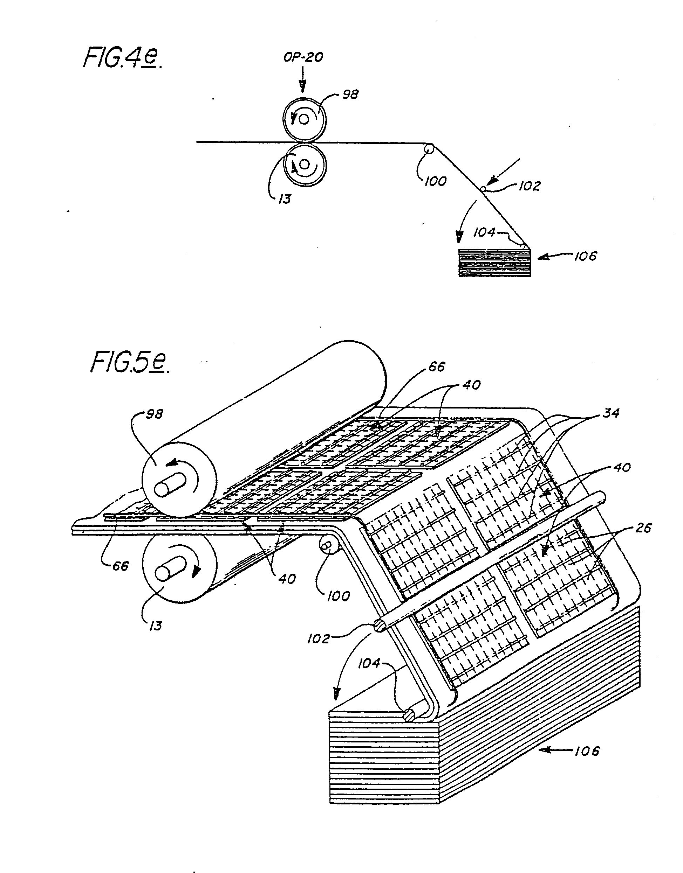

Referring now to Figures 4 and 5, the machine operations are depicted at the upper portion of the drawings, while the lower portion of the drawings depicts the operations performed on the roll of large area solar cell material as the large area solar cell material is

- 33. -

continously advanced along the assembly line.  For
purposes of this discussion, the roll of large area solar
cell material will be referenced by the numeral 9 and
each individual, large area solar cell will be referenced
by the numeral 40.

While the subsequent paragraphs describe the
sequence of work stations which now comprise the
preferred method of fabricating the laminated strip of
large area solar cells, it should be readily apparent
that certain stations may be resequenced, complely
eliminated, or divided into multiple stations without
departing from the spirit and scope of the present
invention.

A.      The Pay-Off Station

In the following description of the assembly line
sequence of operations, successive stations will be
assigned successive "OP-_" reference characters.  Turning
now to Figures 4a and 5a, the roll of solar cell material
9 is shown at the pay-off station OP-1 as locked onto a
pay-off mandril 42 for rotatably and continuously
dispensing a pair of spaced, large area solar cells 40
from said roll at the rate of approximately 15 feet per
minute.  In the preferred embodiment, the roll of solar
cell material 9 is 1000 to 4000 feet in length and
approximately 26 inches in width.  The 26 inch width
dimension is necessary in order for the roll 9 to
transversely accommodate two 12 inch long, large area
solar cells 40.  Obviously, the width dimension of the
roll 9 will change as the length dimension of the large
area solar cells is modified to meet specific power
requirements.  Regardless of its dimension, each large
area solar cell 40 comprises a common, electrically-conductive substrate 11 upon which a
plurality of semiconductor layers are deposited and
covered by an upper transparent, conductive coating 22 of
indium tin oxide. The large area solar cells 40 are
longitudinally and transversly defined by spaces 44, said
spaces 44 preferably developed by the application of the
insulating material to prevent the transparent,
conductive coating 22 from communicating electrically
with the semiconductor layers, as previously described.
Not only do the spaces 44 define adjacent large area
solar cells 40, but they permit the cells to be cut into
sheet form without shorting and destroying the electrical
operability of the cells.

It should be apparent to one of ordinary skill
that the size of each large area solar cell 40 may vary
with the power requirements of the specific application
for which it is manufactured. The number of large area
solar cells 40 longitudinally or transversely spaced on
the roll of solar cell material 9 would then vary
correspondingly. The assembly line machinery is readily
adapted, through well known numerical control systems, to
accommodate large area solar cells of varying dimensions.

It should also be readily apparent that a roll of
dark paper could be adhesively secured atop the
encapsulated active surface of the laminated strip of
electrically-interconnected large area solar cells. The
dark paper would serve as a safety meausre to
substantially prevent solar energy from activating the
cells before installation thereof is complete.

B.        The Bus Bar Laminating Station

At this work station, OP-2, reels of copper busbar
tape 46 are spacedly laminated, in substantially vertical columns onto the spaces 44 on the exterior surface of
each of the large area solar cells 40. The number and
spacing of the copper busbars 34 so formed depends on the
size and shape of the electrically-isolated segments of
the large area solar cells which the busbars 34 are
adapted to electrically-interconnect. While only four
reels 46 of copper busbars 34 are illustrated in Figure
4a and 5a, in the preferred embodiment, six reels 46 will
be used to fix six busbars 34 to the solar cell surface
with a thin layer of electrically- insulated silicone
adhesive. The insulating adhesive prevents the copper
busbars 34 from making direct electrical contact with the
solar cell material.

As described in the foregoing section (II), the
copper busbars 34 preferably extend from adjacent the
lower edge of each large area solar cell 40 onto the
peripheral border 36 and will be severed from the reels
about midway through the peripheral border 36 formed
adjacent the top edge of each large area solar cell 40.
More particularly, the upper end of each of the copper
busbars 34 terminate about 1/8 to 1/4 inch into the 1/4
to 1/2 inch wide upper peripheral border 36.

C.     The Grid Printing and Busbar Connecting
Station

As the name implies, at this station, OP-3, the
electrically-conductive grid pattern 24 is printed onto
the surface of the transparent, conductive coating of
each large area solar cell 40 with silver paste or other
highly electrically- conductive material. Simultaneously
therewith, the grid patterns 24 are
electrically-connected to the copper busbars 34 in such a
manner that every electrically-operative, isolated

segment of the large area solar cell surface is
electrically-connected to one of the busbars 34. In the
preferred embodiment, and as best illustrated in Figures
2a and 2b, the isolated segments 26 of the large area
solar cells 40 are arranged in horizontally and
vertically spaced rows and columns. It is, therefore,
easiest to connect the grid patterns 24 to the vertically
oriented copper busbars 34 by applying a dot of silver
paste 35 to an adjacent copper busbar. Due to the
relatively small size of the cells 40 in Figures 5a
through 5e, the isolated segments 26, the grid patterns
24 and the connecting dots of silver paste 35 are best
seen in Figure 2a. It should be apparent that the
isolated segments 26, the grid patterns 24 and the silver
paste 35 depicted in Figure 2a are illustrative of the
isolated segments 26, the grid patterns 24 and the silver
paste 35 applied to the solar cell material 9 of Figure
5a.

D. The Drying Station

The roll of solar cell material 9 which now has
applied thereonto a plurality of
electrically-interconnected segments 26 forming the large
area cells 40 is advanced into a drying station, OP-4.
At this station, an elongated oven 48 operates to dry the
grid patterns 24 and the dots of silver paste 35 which
have just been screen printed onto the surface of each
large area solar cell 40. The oven 48 may include heat
graduations from the upstream end until a temperature of
150-170µo C is attained. At a 150-170µo C temperature,
the patterns and dots are typically cured in 15-30
minutes.

E.    The Cutting Station

After the large area cells 40 are dried in the oven 48 of the drying station OP-4, they travel to a cutting station OP-5. At this station, the large area solar cells 40 are severed from the elongated roll of solar cell material 9 so as to form a plurality of individual, sheet-like, large area solar cell plates (the plates will be continued to be referred to by the reference numerial 40). The cutting machine 50 may take one of several different forms. It may either include a plurality of longitudinally and transversely arranged cutting blades adapted to sever the large area solar cell plates 40 from the roll of solar cell material 9 by making longitudinal and transverse incisions therethrough. Alternatively, the cutting machine may be adapted to sever the large area solar cell plates 40 from the roll of solar cell material 9 in a one-step blanking operation. In either event, the large area solar cell plates 40 drop onto a conveyor belt 52, see Figures 4b and 5b, for advancement to subsequent stations. The scrap material 41 from which the plates were cut is simultaneously wound about a take-up roller 54. Obviously, grooves, pins or other like positioning elements may be employed on the conveyor belt to properly arrange the large area solar cell plates 40 thereon.

F.    The Testing Station

Turning now to Figure 4b and 5b, the individual, large area solar cell plates 40 proceed along the assembly line on the conveyor belt 52 (trained between rollers 52a and 52b) to an electrical test station OP-6. At station OP-6, each of the large area solar cell plate 40 are tested for overall electrical performance. This is easily accomplished because electrical probes 56 may be lowered to connect the copper busbars 34 and the conductive substrate surface. Access to the common substrate may be provided from the underside of conveyor belt 58. At this point, it should be mentioned that although the testing station could have been positioned immediately after the grid pattern 24 was printed onto the surface of the transparent, conductive coating 22, it is preferred to test after the plates have been cut from the roll of semiconductor material. At the same time that the electrical probes are lowered to test the large area solar cell plates 40, the results of those tests are stored in memory. Further note, that the substrate exposing station, discussed hereinafter, may precede this test station so as to provide access to the substrate from the upper surface thereof.

G.    The Sorting Station

Immediately downstream of the testing station OP-6 is a sorting station OP-7. At this station, the results from the electrical test station, which have been stored in memory, are used to remove those large area solar cell plates 40 failing to meet preselected electrical output requirements from the assembly line. Note, the large area solar cell plates 40 are removed from the assembly line in pairs see arrow A. More particularly, in .the preferred embodiment, even if only one of each transversely aligned set of two large area solar cell plates is electrically defective or otherwise fails to meet the preselected electrical output requirements, both large area solar cell plates in a transverse column are removed. Obviously, an embodiment in which only the

- 39. -

defective large area cell is removed from the assembly line is also contemplated as part of the invention disclosed herein. The sorting station may also be used to match the currents of the large area solar cells. Since the lowest current provided by the plurality of large area solar cells will be the maximum current generated by the module, cells providing current below a predetermined level will also be removed.

H.      The Orienting Station

Now that electrically-inopertive (E.I.) large area solar cell plates 40 E.I. have been removed from further downstream processing on the assembly line, electrically-operative (E.O.) large area solar cell plates 40 E.O. must be placed in those vacancies. Further note that the electrically-operative cells are current-matched. The orienting station OP-8 performs that operation and orients all large area solar cell plates 40 for downstream processing. Note that, although two electrically-operative solar cell plates are shown simultaneously moving into the vacant assembly line positions, the positions could also be filled by successive operation on a single stack of solar cell plates.

I.      The Substrate Exposing Station

Since all solar cell plates 40 occupying a position on the assembly line conveyor belt 58 are now electrically- operative, the solar cell plates 40 are advanced to a substrate exposing station OP-9. At this station, a machine 60 performs a burnishing operation by lowering a plurality of rotating spindles 61 to remove all layers deposited: onto the upper left hand corner 62 of each large area solar cell plate 40 disposed on the upper portion of the conveyor belt 58; and the lower right hand corner 64 of each large area solar cell plate 40 disposed on the lower portion of the conveyor belt 58. The substrate surfaces thus exposed (see reference numeral 11a in Figure 3) are available for electrical connection.

J.     The Cell Interconnecting Station.

As the large area solar cell plates 40 reach the interconnect station OP-10, a continous insulating cloth tape 66, with spaced, copper strips secured to the bottom surface thereof, is applied, by rotatable pressure rollers 68, to the peripheral, electrically-insulated border 36 onto which the copper busbars 34 extend. The copper strips extend from the first busbar 34a of a large area solar cell plate 40a (see Figure 5b), across the other busbars 34b, 34c and 34d on that plate 40a and terminate after covering the exposed substrate 11 of the downstream large area solar cell plate 40b. In this manner adjacent, large area solar cell plates 40a and 40b are prepared to be electrically-interconnected, in series (busbars of one plate to the exposed substrate of the adjacent plate). The connection will be completed at a downstream loation, as described in the following section. Note that, although not required, the cloth tape 66 may include an insulating layer covering the space between adjacent large area solar cell plates 40 to prevent accidental shorting. The application technique, depicted in Figure 4b, includes supply rolls of tape 70 from which the cloth tape 66 is secured to the plates 40

- 41. -

by the pressure roller 70. Obviously, other conventional application methods may be employed.

### K. The Welding Station

Referring now to Figures 4c and 5c, the elecrically-interconnected, large area solar cell plates 40 are advanced along the assembly line 58 to a welding station OP-11, at which station welding rods 72 are lowered from welding machine 74 to permanently fuse the copper, electrically- conductive strip affixed to the cloth tape 66 to the exposed portion 11a of the stainless steel substrate 11 of each large area solar cell plate 40. While this method of connection has proved satsifactory, the copper strip could be riveted to the substrate prior to welding for insuring that the copper strip would be permanently secured to the substrate.

### L. The Soldering Station

Now that one end of each of the cloth covered copper strips has been permanently secured to the substrate 11 of each of the individual large area solar cell plates 40, the completion of the electrically-interconnecting procedure is accomplished by soldering the copper strip of the cloth tape 66 to each of the copper busbars 34 at the soldering station OP-12. In this operation, a plurality of heated tips 76 are lowered from soldering machine 78 to contact each busbar-copper tape intersection for forming an electrically-conductive connection therebetween. At this point, (1) the isolated segments 26 of each large area solar cell plate 40 are electrically-interconnected by the busbars 34 and the cloth covered copper tape 66 to provide an overall, large area solar cell electrical output and, (2) each large area solar cell plate 40 is electrically-interconnected to each adjacent large area solar cell to provide a modular electrical output which is the sum of the output of each individual large area solar cell plate 40.

### M.  The Transfer Station

Still viewing Figures 4c and 5c, the electrically-interconnected large area solar cell plates 40 are moved from the assembly line conveyor belt 58 onto the encapsulating assembly line 80 via a transfer conveyor belt 82, trained between rollers 82a and 82b. Transfer conveyor belt 82 comprises the transfer station OP-13. At this station, each of the large area solar cell plates 40 may also be given a last test for appropriate levels of electrical performance before the encapsulation process begins. The transfer belt 82 is preferably magnetic for transporting the solar cell plates with the bottom surfaces thereof exposed when a magnetic substrate is employed. For non-magnetic substrates, the transfer belt 82 may be apertured with a plurality of positioning flanges between which the substrates would be situated for priming.

### N.  The Lower Priming Station

As the electrically-interconnected, large area solar cell plates 40 move across the transfer conveyor belt 82, the lower substrate surface of said plates 40 is exposed, as mentioned hereinabove, for receiving an adhesion promoting agent at a lower priming station OP-14. The primer may be spread by a roller or sprayed by a plurality of nozzels 84 in a supply manifold 86 onto the exposed, lower, substrate surface of the large area solar cell plates 40. The purpose of the primer is to promote adhesion of the lower encapsulating covering to the bottom of the large area solar cell plates. The adhesion promoting agent is applied as a mono-layer, typically 15-100 angstroms thick.

O.     The Lower, Encapsulant-Introducing Station

Referring to both Figures 4d and 5d, as well as Figures 4c and 5c, the remainder of the assembly line process for fabricating a modularized roll of large area solar cell plates 40 is illustrated. The lower encapsulant supply roller 88 is shown in phantom lines in Figures 4c and 5c for purposes of indicating that the encapsulant is introduced immediately following the priming operation OP-14. The bottom encapsulant supply roller 88 is shown in solid lines in Figures 4d and 5d to show, in a single drawing, the encapsulation process. More particularly, after being coated with the adhesion promoting agent at the lower priming station OP-14, the electrically-interconnected large area solar cell plates 40 are spacedly deposited onto a continuous strip of flexible, lightweight, pigmented, electrically-insulating, protective encapsulation material, such as TEDLAR (registered trademark of DuPont Corp.) at the lower, encapsulant-introducing station OP-15. The encapsulant includes an extruded layer of ethylvinylacetate on one surface thereof, the encapsulant being typically 5 mils thick and the ethylvinylacetate being 18 mils thick.

- 44. -

The lower encapsulation material 90 is advanced along the encapsulation assembly line 80 by a drive motor 93 which intermittently but continuously, advances a take-up roller 13 about which the lower encapsulation material is wound.

P.     The Upper Priming Station

Prior to introducing the upper encapsulant, the top surface of the electrically interconnected, large area solar cell plates 40 must be primed with an adhesion promoting agent. The top, electrically-interconnected surface is thus coated with that priming agent at the upper priming station OP-16. In Figure 4d, the adhesion promoting agent is illustrated as being applied as a monolayer, about 15-100 angstroms thick, by apertured supply manifold 92. Obviously, the adhesion promoting agent could also be applied by a coating roller or by other conventional apparatus.

Q.     The Upper Encapsulant Introducing Station

After being covered by the adhesion promoting agent at the upper priming station OP-16, the upper surface of the spaced, electrically-interconnected, lower-encapsulated, large area solar cell plates 40 are ready to be encapsulated by flexible, lightweight, electrically-insulating, protective, light-transmissive, encapsulation material 94, such as TEDLAR (registered trademark of DuPont Corp.) at the upper, encapsulant-introducing station OP-17. The upper encapsulant is about 5 mils thick and has extruded onto one surface thereof a layer of ethylvinylacetate which is about 18 mils thick. While in the preferred embodiment, the encapsulation material is a continuous stip, it is possible to encapsulate with large area encapsulating sheets which could either be (1) contiguously applied to form a continuous upper encapsulating layer, or (2) spacedly applied if it is desired to expose the electrical leads between large area solar cell plates 40.

The upper encapsulation material 94 is wound about a supply roller 96 for intermittent, continuous advancement along the encapsulation assembly line 80 as the take-up roller 13 about which the upper encapsulation material 94 is wound simulataneously advances. As the upper encapsulating supply roller 96 rotates, the upper encapsulating material 94 is introduced onto the upper surface of the primed, electrically-interconnected, large area solar cell plates 40.

R.    The Encapsulation Station

Now that the upper and lower encapsulating material, 90 and 94 respectively, have been introduced to cover the upper and lower surfaces of the large area solar cell plates 40, the encapsulation process is completed at the encapsulation station OP-18. More particularly, in order to flow and cure the upper and lower layers of ethylvinylacetate, the encapsulated, spaced, electrically-interconnected large area solar plates 40 are intermittently, but continuously, advanced through the encapsulation chamber 96. The encapsulation chamber 96 is first heated to approximateky 130μo C and then air is evacuated. A diaphragm is used to exert a uniform pressure of about one atmosphere against the

- 46. -

surface area of both the upper and lower strips of encapsulating material. At the pressure of one atmosphere and temperature of 130µo C, the ethylvinylacetate flows and cures, thereby bonding the upper and lower encapsulating layers to the large area solar cell plates. Since the bonding agent was spread in a vacuum, no bubbles are formed. Further details of one possible design for the encapsulation chamber 96 are disclosed in the U.S. Patent Application Serial No. 347,779, referenced hereinabove.

S..    The Take-Up Station

All that remains to complete fabrication of the encapsulated, spaced, electrically-interconnected, large area solar cell plates 40 is to package them for future use. This is accomplished, in the preferred embodiment, at the take-up station OP-19 illustrated in Figures 4d and 5d. This simply involves the rotation of take-up roller 13 by the drive motor, 93, in the manner previously described. The result is a roll 13 of modularized, spaced, electrically-interconnected, large area solar cell plates 40. The modularized roll may be easily removed from the take-up station OP-19 and conveniently taken to a warehouse for storage or a construction site for use.

T.    The Alternate Take-Up Station

Rather than winding the encapsulated, spaced, electrically-interconnected, large area solar cell plates 40 about the take-up roller 13, Figures 4e and 5e show an alternative stacking arrangement which is accomplished at the alternate take-up station OP-20. At take-up station OP-20, the continous strip of encapsulated, large area solar cell plates 40 is threaded between rotatable driven roller 13 and pressure roller 98 for continous, but intermittent, advancement. The free end of the continous, large area strip of encapsulated, large area solar cell plates 40 is directed about folding-rods 100, 102 and 104 to form a stack of 106 of modularized spaced, electrically- interconnected, large area solar cell plates 40. The modularized stack may be easily removed from the alternate take-up station OP-20 and conveniently taken to a warehouse for storage or a construction site for use.

IV.     The Method of Fabricating a Continuous
Strip of

Large Area Solar Cells

With the foregoing explanation of the assembly line machinery, the method of fabricating a continuous, lightweight, laminated strip of encapsulated, spaced, electrically- interconnected, large area solar cells from an elongated roll of solar cell material becomes readily apparent. The solar cell material is formed of a substate having deposited thereon a plurality of semiconductive layers and covered by an electrically-conductive, light-transmissive, transparent, conductive coating. The solar cell material is further divided into a plurality of large area solar cells. In a very comprehensive form, the fabricating method will include the steps enumerated below. However, certain steps may be interchanged, eliminated, divided and

- 48. -

supplemented without altering the scope of this
invention.:

    1.   Introducing the roll of solar cell material at
the pay-off station of an assembly line;

    2.   Laminating a plurality of busbars, in
substantially vertical columns onto the transparent,
conductive coating forming the exterior surface of each
of the large area solar cells;

    3.   Printing the electrically-conductive grid
pattern onto the surface of the transparent, conductive
coating of each large area solar cell and simultaneously
electrically-interconnecting the grid patterns to the
busbars;

    4.   Drying the grid patterns and dots of
electrically-connections in an oven;

    5.   Severing, from the elongated roll of solar
cell material, the plurality of individual sheet-like,
large area solar cell plates;

    6.   Testing each of the large area solar cell
plates for overall electrical performance and storing the
results of those tests in memory;

    7.   Removing those large area solar cell plates
failing to meet preselected electrical output
requirements from further processing;

    8.   Replacing the electrically-inoperative large
area solar cell plates with electrically-operative large
area solar cell plates;

- 49. -

9. Exposing a portion of the substrate of each of the large area solar cell plates;

10. Electrically-interconnecting, in series, with an elongated, electrically-conductive strip, the adjacent large area solar cell plates;

11. Welding the busbars to the elongated, electrically-interconnecting strips;

12. Soldering the electrically-interconnecting strips to each of the busbars of the individual large area solar cell plates;

13. Testing each of the large area solar cell plates which have now been electricaly-interconnected;

14. Applying a priming agent to the lower surface of the electrically-interconnected, large area solar cell plates;

15. Introducing a continuous, flexible, pigmented, electrically-insulating, lower encapsulating layer onto which the electrically-interconnected, primed, large area solar cell plates are placed;

16. Priming the upper surface of the electrically-interconnected, large area solar cell plates with a adhesion-promoting agent;

17. Introducing a continuous, flexible, electrically-insulating, light-transmissive, upper encapsulant onto the upper surface of the primed, electrically- interconnected, large area solar cell plates;

18.   Encapsulating the spaced, electrically-interconnected large area solar cell plates between the upper and lower encapsulating material by flowing and curing;

19.   Rolling the encapsulated, electrically-interconnected, spaced, large area solar cell plates onto a take-up roller so as to form a modularized roll of spaced, electrically-interconnected, large area solar cell plates;

20.   As an alternative to the rolling step of Paragraph 19, supra, folding the encapsulated strip of electrically- interconnected, encapsulated, spaced, large area solar cell plate on top of one another, whereby a modularized stack of large area solar cell plates is produced.

V.   Uses

The modularized roll or modularized stack of electrically-interconnected, spaced, large area solar cell plates is specially suited for certain electrical power applications.  One preferred use of the present invention is for installation onto the roof of a residential or industrial building.  The method of such installation would include the steps of cutting a solar cell module of a length sufficient to produce a predetermined quantity of power, from the continuous, lightweight, laminated strip of spaced, electrically-interconnected, large area solar cell plates encapsulated by a protective covering. Alternatively, the solar cell modules may be precut at the factory in, for example, 30 foot lengths, which modules may then be electrically interconnected to produce the predetermined quantity of power. In either event, the solar cell module is then readily secured to the roof of the residential or industrial building by simply (1) nailing that solar cell module in the spaces between adjacent large area solar cell plates, or (2) applying an adhesive to the bottom surface of the module. The solar cell module may then be electrically- connected either to an apparatus for storing the electrical output from that solar cell module or directly to the apparatus which requires the electrical power for operation. The instant invention also contemplates the electrical attachment of elongated, at least 20 foot long, positive and negative leads to the anode and cathode of the precut solar cell modules, mentioned hereinabove, before the module is secured to the roof. In this manner, the installation people need not be concerned with electrical connections at possibly awkward locations or under inclimate weather conditions. All connections may be made at the junction box, usually at ground level, after the module has been safely installed.

It should be readily obvious to one ordinarily skilled in the art that a solar cell module so secured to the roof of a residential building or industrial building may be readily repaired. More particularly, should one of the large area solar cells become damaged due to wind, hail, etc., it may be repaired by electrically-disconnecting and physically removing the damaged large area solar cell from the remainder of the large area solar cells of the module. A similarly sized large area replacement solar cell may then be electrically-connected

- 52. -

and physically inserted in the space vacated by the
defective solar cell.  It only remains to seal the
protective covering of the replacement solar cell to the
protective covering of the remainder of the module.

Also of major importance, for roof-top use of the
solar cell module of the instant invention, would be the
incorporation of known safeguards in the final product.
In other words, such known devices as blocking diodes, or
other circuitry for the undirectional flow of current,
etc., may be included with each large area solar cell
priro to encapsulation thereof.  While these devices have
not been illustrated as assembly line stations, their
inclusion in the laminated strip of
electrically-interconnected large area solar cells would
be obvious.

Finally, it should be noted that, while the
laminated strip of electrically interconnected large area
solar cells disclosed and claimed herein is encapsulated
with upper and lower protective coverings of a size which
approximates the size of the large area solar cells, for
specific applications, the size of the encapsulating
coverings may be increased  For example, when the
laminated strip is adapted for use as a roof-top power
supply, it is advantageous that the strip also function
as a shingle to protect the roof from the elements.  In
order to function as a shingle, the width of the
peripheal border portions of the encapsulating coverings
is preferably increased to provide overlap between
adjacent modules of said large area solar cells.  In a
like manner, the module may be modified to accomodate
specific job specifications.

It should be understood that the present invention
is not limited to the precise structure of the
illustrated embodiments.  It is intended that the

- 53. -

foregoing description of the presently preferred methods
be regarded as illustrative rather than as limiting.  It
is the claims which follow, including all equivalents,
which are intended to define the scope of this invention.

- 54 -

CLAIMS

1. A continuous, lightweight, laminated strip of encapsulated, spaced, electrically-interconnected, large area solar cells, said laminated strip being characterized by:

a plurality of spaced, electrically-interconnected, large area solar cells (40), each said solar cell including a substrate (11) a plurality of semiconductor layers (16a-c) 18a-c, 20a-c) atop the substrate, and an electrically-conductive, light-transmissive, transparent, conductive coating (22) atop the semiconductor layers; and

a flexible, lightweight, electrically-insulating, protective covering (90,94) encapsulating the plurality of spaced, electrically-interconnected large area solar cells, such that a continuous laminated strip (13 106) of electrically-interconnected large area solar cells is provided.

2. A laminated strip according to claim 1, wherein each of the large area solar cells (40) measures approximately 0.092 $m^2$ (one square foot) and is spaced approximately 6 mm (one-quarter inch ) from each adjacent large area solar cell.

3. A laminated strip according to claim 1, wherein each of the large area solar cells (40) measures approximately 51 mm (two inches) in width and 304 mm (twelve inches) in length and is spaced approximately 6mm (one-quarter inch) from each adjacent large area solar cell.

4. A laminated strip according to claim 1, wherein each of the large area solar cells (40) is divided into a plurality of electrically isolated segments (26); a grid pattern (24) is formed on each isolated segment; a plurality of first contact means (34) electrically connect the grid patterns of each large area solar cell; and a plurality second contact means (35) electrically interconnect the first contact means of each solar cell.

5. A laminated strip according to claim 4, wherein the first contact means comprises a plurality of copper busbars (34) and the second contact means comprises a plurality of electrically-conductive strips (37).

6. A laminated strip according to claim 1, wherein each large area solar cell plate (40) is electrically-interconnected in series; and the busbar (37) electrically-interconnecting each of the large area solar cell plates is of uniform cross-sectional area.

7.. A method of fabricating a continuous, lightweight, laminated strip of encapsulated, spaced, electrically-interconnected, large area solar cells from an elongated roll of solar cell material, the solar cell material including at least a substrate having deposited thereon a plurality of semiconductor layers, said solar cell material being divided into a plurality of large area solar cells, said method being characterized by the steps of:

moving the solar cell material from the pay-off station, through a plurality of work stations;

electrically-interconnecting adjacent large area solar cells at one of the work stations; and

encapsulating the spaced, electrically-interconnected, large area solar cells between light weight, elongated, continuous, flexible, electrically-insulating upper and lower protective coverings at another one of the work stations, such that a continuous laminated strip of large area solar cells is produced.

0111394

- 56 -

8. A method according to claim 7, including the further step of securing a plurality of first contact means to each large area solar cell at a first work station.

9. A method according to claim 8, wherein the large area solar cells are divided into a plurality of electrically-isolated segments, and the method includes the further step of printing a plurality of grid patterns onto the transparent, conductive coating of each electrically isolated segment.

10. A method according to claim 9, including the additional step of electrically interconnecting, with second contact means, the electrically-isolated segments of each large area solar cell to adjacent first contact means on that large area solar cell at a second work station.

11. A method according to claim 10, including the additional step of cutting the large area solar cells to a predetermined size from the solar cell material at a third work station.

12. A method according to claim 11, including the step of testing each large area solar cell for electrical operability at a fourth work station.

13. A method according to claim 12, including the additional step of removing electrically-inoperable large area solar cells from the assembly line at a fifth work station.

14. A method according to claim 13, including the additional step of replacing removed large solar cells at a sixth work station, so that large area solar cells are regularly and continuously spaced along the assembly line.

15. A method according to claim 14, including the step of introducing a continuous roll of flexible, electrically-insulating, lower protective covering for lamination onto the bottom surface of the spaced, cut and electrically-operative large area solar cells at a seventh work station.

16. A method according to claim 14, including by the step of priming the large area solar cells with an adhesion promoting agent prior to lamination with the lower protective covering.

17. A method according to claim 16, including electrically interconnecting adjacent large area solar cells in series, with third contact means, at an eighth work station.

18. A method according to claim 17, including the step of introducing a continuous roll of flexible, electrically-insulating, light-transmissive, upper protective covering at a ninth work station for lamination onto the upper surface of the large area solar cells.

19. A method of installing a solar cell module onto the structure of appurtenant the structure of a residential or industrial building, said method being characterized by the steps of:

cutting a solar cell module, of a length sufficient to produce a predetermined supply of power, from a continuous, lightweight laminated strip of spaced, electrically-interconnected, large area solar cells encapsulated by a protective covering;

securing the solar cell module to the structure of the building, and

electrically-connecting the solar cell module for use.

20. A method according to claim 19, wherein the solar cell module is electrically-connected to means for storing the electrical output thereof.

21. A method according to claim 19, wherein the solar cell module is electrically connected to apparatus requiring electrical power for operation.

22. A method according to claim 19, wherein the solar cell modules include peripheral border portions of increased width, and the method includes the additional step of overlapping adjacent modules in shingle-like fashion to protect the surface of the structure to which the modules are secured.

23. A method of replacing a damaged large area solar cell which is electrically-interconnected to adjacent large area solar cells in a solar cell module installed on the structure of a residential or industrial building, the module including a continous length of spaced, electrically interconnected large area solar cells incapsulated by a protective covering, the method characterized by the steps of:

electrically disconnecting and physically removing the damaged large area solar cell from the remainder of the large area solar cells of the module;

electrically connecting and physically inserting a similarly sized large area replacement solar cell to the remainder of the large area solar cells of the module; and

sealing the protective covering of the replacement solar cell to the protective covering of the module.

24. A solar cell module characterized by a preselected number of lightweight, flexible, laminated, encapsulated, spaced, electrically interconnected large area solar cells (40), each solar cell including a substrate (11) and a flexible, lightweight, electrically interconnecting, protective covering encapsulating the spaced, electrically interconnected large area solar cells; and

elongated positive and negative leads electrically connected to and extending from said module, such that the module is adapted to be electrically connected at a position remote from the structure to which the module is secured.

25. A module according to claim 24, wherein the positive and negative leads are at least 6m (20 feet) in length.

26. A module according to claim 25, wherein the leads are connected to apparatus securing electrical power for operation.

27. A module according to claim 25, wherein the leads are connected to means for storing the electrical output of the module.

28. A module according to claim 25, wherein the module is secured to the roof of a building and the leads are electrically connected for operation at a position below the roof elevation.

FIG.I.

FIG.2a.

FIG.2*b*.

2/7

FIG.3.

FIG.4a.

OP-1  OP-2  OP-3  OP-4  OP-5

FIG.5a.

0111394

FIG. 4b.

OP-6    OP-7    OP-8    OP-9    OP-10

56    60    70    66    68

52a    58    61

FIG. 5b.

61

56    56    56    26

61    40    34    61    40    34a    70    34b    34c    34d    66

40a    40b    40a    40b

34a    34b    34c    34d    66

40 E.I.    40 E.O.    40    70    34

40 E.I.    40 E.O.

4/7

0111394

FIG.4c.

FIG.5c.

5/7

0111394

FIG.4d.

OP-16    OP-17    OP-18    OP-19

92    96

94

90

88

OP-15

93

13

6/7

FIG.5d.

96

92

40

94    40    66    34    40    26

40

66

90    94    26    40    66    26

34

13

88

0111394

FIG.4e.

FIG.5e.